# EUROPEAN PATENT APPLICATION

(11) **EP 2 116 631 A1**
(43) Date of publication of application: **11.11.2009**
(21) Application number: 08155495.8
(22) Date of filing: 30.04.2008
(51) Int. Cl.: C23C 14/34, C23C 14/00

(54) **Sputter target**

(71) Applicant: Applied Materials, Inc., Santa Clara, CA 95054 (US)
(72) Inventor: Mueller, Joachim, 70736 Fellbach (DE); Severin, Daniel, 63477 Maintal (DE); Kreß, Markus, 63165 Muelheim (DE)
(74) Representative: Lang, Christian

(57) **Abstract**

In the present invention a sub-stoichiometric ceramic ZnOₓ: Al target, with 0.3 < x < 1, is used for depositing a ZnO: Al layer in a reactive sputtering process. The process is carried out in an Ar/O₂ atmosphere. The diagram depicts the deposition rate R depending on the oxygen flow in a sputtering process according to the present invention compared with a conventional sputter process using a stoichiometric ZnO target. The upper line x < 1 indicates the deposition rate R when using the inventive target and process. The lower line x = 1, for comparison only, indicates the deposition rate R when using a stoichiometric ceramic ZnO target. It can be seen from the diagram that both processes are quite stable as there are no steep slopes when varying the oxygen flow. However, the line x<1 is above the line x=1. Therefore, a working point P may be selected which has a higher deposition rate R than a corresponding working point P' of a corresponding ceramic target. A higher deposition rate, however, entails a lower bombardment of the deposited layer with oxygen ions. Therefore, the quality of the ZnO: Al layer is improved as far as the conductivity and the etchability of the layer are concerned.

## Description

### FIELD OF THE INVENTION

The present invention relates to a sputter target for the use in a reactive sputtering process for depositing a layer on a substrate, comprising at least a first metal element Me1 of the periodic table, and a quantity of oxygen. Furthermore, the invention relates to a method for manufacturing a layer on a substrate, particularly a TCO (Transparent Conductive Oxide) layer, including providing an above-mentioned sputter target in a process chamber. The invention also relates to a method for manufacturing a thin layer solar cell, comprising the step of: a) depositing a layer on a substrate using a method mentioned above.

### DESCRIPTION OF THE PRIOR ART

Sputter coating is a well-known method for depositing thin films of different materials on a substrate. Sputter processes include eroding material from a target which is then deposited on a substrate. Sputtering processes are often used to deposit metal thin films on a substrate in an inert gas atmosphere, e.g. in an Ar atmosphere.

In order to deposit compound thin films on a substrate, reactive sputtering may be used. In reactive sputtering an appropriate reactive gas is added to the inert gas atmosphere. For example, O₂ may be added to Ar to provide an O₂/Ar atmosphere. The reactive gas reacts with the sputtered material to form a thin compound film on the surface of the substrate.

However, it can not be avoided that reactions of the reactive gas also occur on the surface of sputter target causing "target poisoning". Thus in reactive oxidic sputter processes of metallic targets instabilities of the process may be caused. The instabilities are due to a feedback loop or hysteresis induced by the effects. For example, poisoning of the sputter target reduces the thin film growth rate, thus reducing the use of reactive gas, and thus resulting in even more target poisoning. The deposition rate is considerably reduced when such effects occur.

A further negative effect of reactive sputtering in an oxidic atmosphere is that the substrate is bombarded with negatively charged oxygen ions generated on the surface of the target, particularly at low deposition rates. For example, if a ZnO: Al layer deposited by reactive sputtering has been hit by a large number of oxygen ions, the conductivity of the layer will be reduced. Furthermore, when producing a silicon thin layer solar cell having a ZnO: Al film as a TCO layer, the ZnO: Al layer has to be etched in hydrochloric acid to form a required pattern. However, the bombardment with oxygen ions deteriorates the etchability of the ZnO: Al layer.

Therefore, in order to maintain a high deposition rate, a sputter process would have to be run at or near an unstable operating point. This requires, however, a careful design of the pumping system, the magnetron, the gas supply, and the use of a sophisticated feedback control system for controlling the reactive gas flow.

The problem of process instabilities is reduced by using a ceramic target, e.g. a ZnO target, for producing a ZnO film on a substrate as a TCO (transparent conductive oxide) layer for a thin layer solar cell. There are hardly any process instabilities as the target surface is not being poisoned by other reactive substances due to the oxygen content contained in the target material. On the other hand the deposition rate is low and thus the bombardment with oxygen ions is high. Furthermore, it is difficult to control or vary the oxygen content obtained in the deposited ZnO film.

### OBJECT OF THE INVENTION

It is an object of the present invention to provide a sputter target and a method for manufacturing a layer, particularly a TCO (transparent conductive oxide) layer, as well as a method for manufacturing a thin layer solar cell, wherein the amount/rate of oxygen deposited in the coating film may be controlled while maintaining a high sputter rate, low oxygen bombardment of the deposited film and a stable coating process.

### TECHNICAL SOLUTION

These objects are achieved by providing a sputter target according to claim 1, a method for manufacturing a TCO (transparent conductive oxide) layer according to claim 12, and a method for manufacturing a thin layer solar cell according to claim 16. Features of preferred embodiments are described in the dependent claims.

A sputter target for the use in a reactive sputtering process for depositing a layer on a substrate, particularly a TCO (Transparent Conductive Oxide) layer, according to the invention comprises a ceramic target comprising at least a first metal element Me1 of the periodic table, and a quantity of oxygen, wherein said quantity of oxygen is a sub-stoichiometric quantity.

It is preferred that said sputter target comprises a ceramic material including Me1Oₓ, wherein x < s, and s being a rational number corresponding to the stoichiometric quantity of oxygen in the Me1Oₓ material.

According to the invention, in a sputter deposition process a sub-stoichiometric ceramic target, e.g. a ZnOₓ target with x < 1 is provided. The sputter process is performed in a reactive Ar/O₂ atmosphere. The inventors have found out that by using a sub-stoichiometric target some advantages of ceramic targets may be combined with advantages of a metallic target. First, the process may be stabilized due to the fact that ceramic targets contain a particular amount of oxygen, i.e. there is an intrinsic amount of oxygen which prevents the targets from changing their characteristics significantly within a small variation of the reactive oxygen flow in the process chamber. Furthermore, the flow/amount of oxygen provided during the process may be varied. This allows varying the deposition rate, particularly to increase the deposition rate, while decreasing the bombardment of the coating film with oxygen ions. Furthermore, the stoichiometry between Zn and O in the deposited film may be adjusted to a predetermined value. By means of the inventive target oxidic layers, e.g. TCO (transparent conductive oxide) layers may be deposited in an improved process.

It is preferred that the sputter target comprises a ceramic material including ZnOₓ, wherein 0.3 < x < 1, with Zn as the first metal element. The present invention, however, is not limited to particular oxidic sputter processes, but may be applied to various reactive oxidic sputter processes.

In another embodiment of the invention said sputter target comprises a ceramic material including TiOₓ, wherein x < 2.

Particularly, said sputter target includes an amount of a second metal Me2. In a number of applications, for example when producing thin layer solar cells, a TCO layer doped with a metal, e.g. Al and/or Nb, is required. The amount of Al and/or Nb in the ceramic layer, e.g. ZnO or TiO₂, ensures the proper functionality of the coating film. The metal doping increases the conductivity of the deposited TCO layer.

The doping material is already contained in the target material in order to be transferred to and incorporated in the coating film during the reactive sputter process. It has to be noted that the second metal is included in the coating layer to provide a conductivity of the coating layer, but not to ensure the conductivity of the target. The conductivity of the target according to the invention is ensured by providing a sub-stoichiometric target as claimed in claim 1.

In some applications according to the state of the art doping materials are included in the target material in order to increase the conductivity. However, these doping materials are just auxiliary materials not intended to be part of the coating film. For example, when generating low-e coatings, coating substances like boron (B) or fluorine (F), are contained in a target in order to increase the conductivity of the target. When manufacturing a low-e layer stack including a thin silver layer, however, incorporation of the doping material has to be prevented.

Due to the fact that a bombardment of the coating film with oxygen ions is considerably reduced during the deposition process, the quality of the n-conductive ZnO: Me layer of a thin layer solar cell is considerably improved. Furthermore, in solar cell applications it is necessary to provide an etching step, particularly by using hydrofluoric acid, to structure the TCO layer. The inventors have found out that when using the sputter target and method according to the invention for manufacturing a thin layer solar cell, the process of etching may be improved. The bombardment of the n-conductive layer with oxygen ions during the deposition process may be controlled to be sufficiently low.

Particularly, said sputter target comprises a material including Me1Oₓ: Me2, wherein x < s, and s being a rational number corresponding to the stoichiometric quantity of oxygen in the Me1Oₓ material.

Said sputter target may comprise a ceramic material including ZnOₓ: Me2, wherein 0.3 < x < 1.

In another embodiment of the invention said sputter target comprises a ceramic material including TiOₓ: Me2, wherein x < 2.

In a preferred embodiment, the second metal material Me2 included in said target is Al and/or Nb.

It is preferred that the amount of Al and/or Nb included in said target is determined by a ratio between Al₂O₃ and ZnO or Nb₂O₅ and TiO₂ in a range between a first value of 0.2 wt.-% and a second value of 6 wt.-%, especially 0.5 wt.-% and 3 wt.-%, the first value and the second value, respectively, referring to a stoichiometric ZnO and/or TiO₂ material.

It is particularly preferred that the amount of Al and/or Nb included in said target is determined by a ratio between Al₂O₃ and ZnO or Nb₂O₅ and TiO₂ in a range between a first value of 0.5 wt.-% and a second value of 2 wt.-%, the first value and the second value, respectively, referring to a stoichiometric ZnO and/or TiO₂ material.

The inventive method for manufacturing a layer on a substrate, particularly a TCO (Transparent Conductive Oxide) layer, comprises the steps of:
a) Providing a sputter target as described above in a process chamber;
b) Providing an atmosphere including at least a ratio of oxygen in said process chamber;
c) Sputtering coating material from said sputter target; and
d) Depositing said TCO layer on said substrate in a reactive sputtering process.

Particularly, said layer to be manufactured is a layer including a first metal element Me1, particularly Zn or Ti, of the periodic table, and oxygen.

It is preferred that the oxygen is contained in the layer in a predetermined substoichiometric or stoichiometric quantity.

Particularly, the TCO layer is a ZnO: Me2 layer, wherein Me2 is a second metal element Me2, especially Al. The TCO layer may also be a TiO₂: Me2 layer, wherein Me2 is a second metal element Me2, especially Nb.

Said atmosphere provided in step b) may be a reactive Ar/O₂ atmosphere. The flow/ content of O₂ in the atmosphere within the coating chamber may be varied to provide a process having a high deposition rate, high stability, and the coating film comprises a predetermined (e. g. a sub-stoichiometric or stoichiometric) amount/concentration of oxygen.

A method for manufacturing a thin layer solar cell according to the invention comprises the steps of: a. Depositing a layer on a substrate by use of a method as described above.
The layer may be deposited on top of another layer deposited on a substrate, e.g. on top of a buffer layer.

Said method may include a further step: b. Etching said layer, especially ZnO:Al. Particularly, etching is performed in HCl for generating a rough surface on top of the layer. Afterwards, an absorber layer (system) of a solar cell may be deposited on top of the roughened surface. Another layer or layer system/ layer stack may be deposited on top of the first layer, e.g. an absorber layer and a contact layer. This layer stack may include additional dielectric layers in order to improve the cell efficiency due to an enhanced optical performance.

### BRIEF DESCRIPTION OF THE DRAWINGS

Further features and advantages of the invention will be apparent from the following description of a preferred embodiment with reference to the appended drawings. The figures illustrate:
- Figs. 1a and 1b: schematic diagrams illustrating the use of a metallic sputter target according to the prior art;
- Figs. 2a and 2b: schematic diagrams illustrating the use of a ceramic ZnO target according to the prior art; and
- Figs. 3a and 3b: schematic diagrams illustrating the use of a ZnOₓ: Al target according to the present invention.

### DESCRIPTION OF A PREFERRED EMBODIMENT

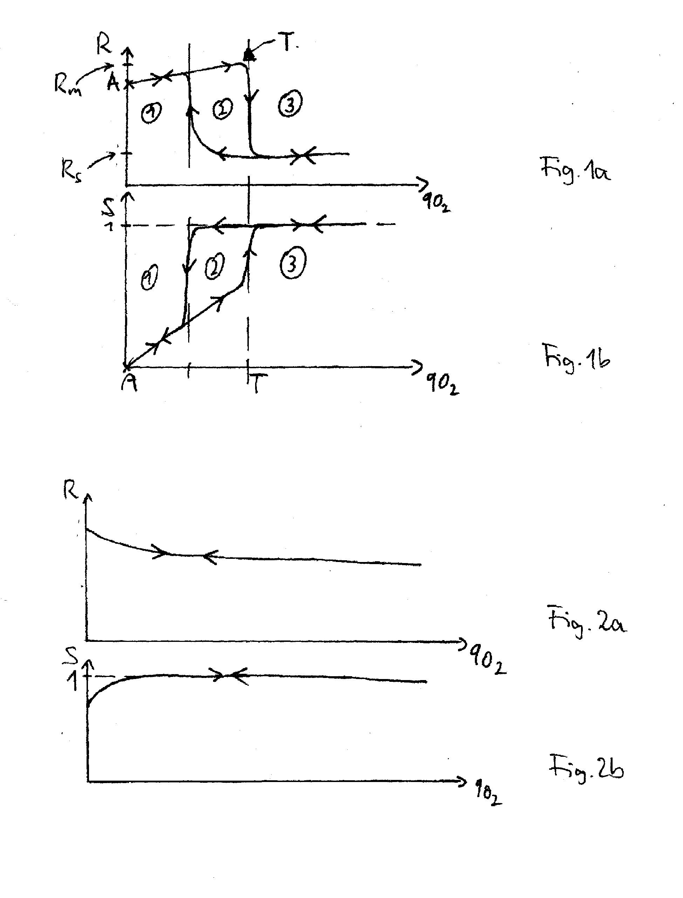

Figs. 1a and 1b illustrate the hysteresis and the stoichiometric proportion, respectively, depending on the O₂ flow when depositing a ZnO film from a metallic target in a reactive sputter process.

In Fig. 1a the deposition rate R is indicated responsive to the oxygen flow. When increasing the oxygen flow from a starting point A in an area of oxygen flow indicated with (1) and (2) (first branch of the hysteresis loop) the maximum deposition rate R is reached immediately before reaching an instable transition point T. When further increasing the oxygen flow into an area of oxygen flow indicated with (3), the deposition rate R decreases rapidly to a more or less stable value Rₛ. At this point, the deposition rate is quite low while the process is stable over a wide range. Even when decreasing the oxygen flow into the area of oxygen flow indicated with (2) the deposition rate does not vary considerably (second branch of the hysteresis loop). Only when approaching the area of oxygen flow indicated with (1) the deposition rate increases to converge with the first branch of the hysteresis loop in the area (1).

In the area of oxygen flow indicated with (3) the process is quite stable. However, the bombardment of the coating film with oxygen ions is quite high thus reducing the performance of the ZnO layer and the possibility of achieving a sufficient rough surface structure after etching of the layer. Therefore, it is preferred to sputter near the instable transition point T in first branch of the hysteresis loop.

Fig. 1b depicts the stoichiometry S between 0 and Zn in the coating film. Starting at point A (no oxygen), the oxygen flow is increased, thus increasing the oxygen ratio in the deposited film (first branch of the hysteresis loop). When further increasing the oxygen flow, the stoichiometric relation between O and Zn reaches the value of 1 when exceeding the transition point T into the area (3). When reducing the oxygen flow beyond the transition point T into section (2) the stoichiometric value of 1 is considerably maintained (second branch of the hysteresis loop) until reducing the oxygen flow into area (1).

Fig. 2a and 2b illustrate the deposition rate R and the stoichiometry of oxygen in a ZnO coating film, respectively, depending on the oxygen flow in the coating chamber when depositing a ZnO film from a ceramic target. The deposition rate R and the stoichiometry are substantially constant over a wide range of oxygen flow, i.e. the process is quite stable. However, it is difficult to control the portion of the surface of the target covered with oxygen. Therefore, the deposition rate is quite low and the bombardment of the substrate by oxygen ions is high.

In solar cell applications, e.g. when manufacturing thin layer solar cells, transparent conductive oxide (TCO) layers, e. g. ZnO layers doped with an amount of Al, are required.

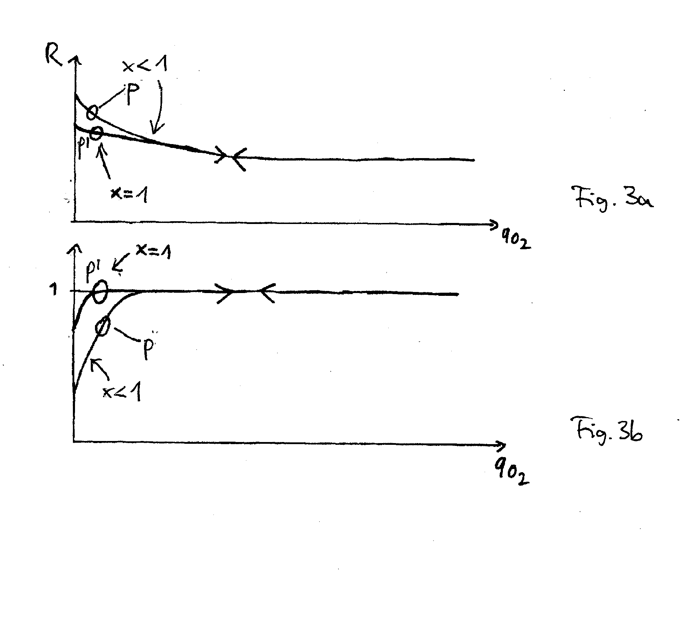

Fig. 3a illustrates the deposition rate R of a ZnO: Al layer depending on the oxygen flow in a sputtering process according to the present invention. In the present invention a sub-stoichiometric ZnOₓ: Al target, with 0.3 < x < 1, is used in a reactive sputtering process in an Ar/O₂ atmosphere.

The upper line x < 1 indicates the deposition rate R when using the inventive target and process. The lower line x = 1, for comparison only, indicates the deposition rate R when using a stoichiometric ceramic ZnO target. It can be seen from Fig. 3a that both processes are quite stable as there are no steep slopes when varying the oxygen flow. However, the line x<1 is above the line x=1. Therefore, a working point P may be selected which has a higher deposition rate R than a corresponding working point P' of a corresponding ceramic target. A higher deposition rate, however, entails a lower bombardment of the deposited layer with oxygen ions. Therefore, the quality of the ZnO: Al layer is improved as far as the conductivity and the etchability of the layer are concerned.

As indicated in Fig. 3b the stoichiometry of oxygen relative to Zn in the coating film may be adjusted in a wider range when using the target x<1 according to the invention. For example, at a working point P the coating layer has a sub-stoichiometric oxygen content, whereas in a corresponding working point P' of a ceramic target the coating film contains a stoichiometric content of oxygen.

It can be summarized that when using metallic targets in a reactive sputtering process, effects of poisoning and hysteresis destabilize the process. In order to increase the stability of the process, an expensive and complex process control has to be implemented. On the other hand, when using ceramic targets in a reactive sputtering process, the deposition rate is quite low and there is no effective way to reduce the bombardment of the coating film with oxygen ions. The present invention combines advantages of metallic and ceramic targets and it has been shown that using a sub-stoichiometric ZnOₓ: Al target allows for a high deposition rate in a stable sputter coating process and an unexpectedly good quality of a ZnO: Al layer produced with the target and the corresponding method.

## Claims

1. A sputter target for the use in a reactive sputtering process for depositing a layer on a substrate, comprising a ceramic target comprising at least a first metal element Me1 of the periodic table, and a quantity of oxygen,
**characterized in that**
said quantity of oxygen is a sub-stoichiometric quantity.

2. The sputter target of claim 1,
**characterized in that**
said sputter target comprises a ceramic material including Me1Oₓ, wherein x < s, and s being a rational number corresponding to the stoichiometric quantity of oxygen in the Me1Oₓ material.

3. The sputter target of claim 2,
**characterized in that**
said sputter target comprises a ceramic material including ZnOₓ, wherein 0.3 < x < 1.

4. The sputter target of claim 2,
**characterized in that**
said sputter target comprises a ceramic material including TiOₓ, wherein x < 2.

5. The sputter target of any of the previous claims,
**characterized in that**
said sputter target includes an amount of a second metal material Me2.

6. The sputter target of claim 5,
**characterized in that**
said sputter target comprises a material including Me1Oₓ: Me2, wherein x < s, and s being a rational number corresponding to the stoichiometric quantity of oxygen in the Me1Oₓ material.

7. The sputter target of claim 6,
**characterized in that**
said sputter target comprises a ceramic material including ZnOₓ: Me2, wherein 0.3 < x <1.

8. The sputter target of claim 6,
**characterized in that**
said sputter target comprises a ceramic material including TiOₓ: Me2, wherein x < 2.

9. The sputter target of any of the previous claims 5 to 8,
**characterized in that**
wherein said second metal Me2 included in said target is Al and/or Nb.

10. The sputter target of claim 9,
**characterized in that**
the amount of Al and/or Nb included in said target is determined by a ratio between Al₂O₃ and ZnO or Nb₂O₅ and TiO₂ in a range between a first value of 0.2 wt.-% and a second value of 6 wt.-%, the first value and the second value, respectively, referring to a stoichiometric ZnO or TiO₂ material.

11. The sputter target of claim 10
**characterized in that**
the amount of Al and/or Nb included in said target is determined by a ratio between Al₂O₃ and ZnO or Nb₂O₅ and TiO₂ in a range between a first value of 0.5 wt.-% and a second value of 2 wt.-% , the first value and the second value, respectively, referring to a stoichiometric ZnO or TiO₂ material.

12. A method for manufacturing a layer on a substrate, particularly a TCO (Transparent Conductive Oxide) layer, comprising the steps of:
a. Providing a sputter target according to any of the previous claims in a process chamber;
b. Providing an atmosphere including at least a ratio of oxygen in said process chamber;
c. Sputtering coating material from said sputter target; and
d. Depositing said layer on said substrate in a reactive sputtering process.

13. The method of claim 12,
**characterized in that**
said layer to be manufactured is a layer including a first metal element Me1 of the periodic table, particularly Zn or Ti, and oxygen.

14. The method according to any of the previous claims 12 to 13,
**characterized in that**
said layer is a Me1O: Me2 layer, wherein Me2 is a second metal material, especially Al and/or Nb.

15. The method according to any of the previous claims 12 to 14,
**characterized in that**
said atmosphere provided in step b) is a reactive Ar/O₂ atmosphere.

16. A method for manufacturing a thin layer solar cell, comprising the step of:
a. Depositing a layer on a substrate by use of a method according to any of the previous claims 12 to 15.

17. The method according to claim 16,
**characterized in that**
said method includes a further step:
b. Etching said layer.
